# EUROPÄISCHE PATENTSCHRIFT

(11) **EP 4 192 035 B1**
(45) Veröffentlichungstag und Bekanntmachung des Hinweises auf die Patenterteilung: **03.09.2025**
(21) Anmeldenummer: 22210982.9
(22) Anmeldetag: 02.12.2022
(51) Int. Cl.: H04R 19/00, H04R 17/00, H04R 31/00

(54) **MEMS-SCHALLWANDLER MIT EINER DÄMPFUNGSSCHICHT AUS KLEBSTOFF**
MEMS SOUND TRANSDUCER WITH AN ADHESIVE DAMPING LAYER
TRANSDUCTEUR ACOUSTIQUE MEMS AVEC UNE COUCHE D'AMORTISSEMENT ADHÉSIVE

(30) Priorität: 03.12.2021 DE 102021131976; 15.12.2021 DE 102021133329
(43) Veröffentlichungstag der Anmeldung: 07.06.2023
(73) Patentinhaber: USound GmbH, 8020 Graz (AT)
(72) Erfinder: Rusconi Clerici Beltrami, Andrea, 1130 Wien (AT); Bottoni, Ferruccio, 8020 Graz (AT)
(74) Vertreter: Canzler & Bergmeier Patentanwälte Partnerschaft mbB

(56) Entgegenhaltungen:
- DE-A1- 102015 114 242
- US-A1- 2017 325 030

## Beschreibung

Die vorliegende Erfindung betrifft eine Wandlereinheit für einen MEMS-Schallwandler mit einem Träger, zumindest einem Wandlerelement, das mit dem Träger verbunden ist und entlang einer Hubachse auslenkbar ist, einem Koppelelement zum Verbinden des Wandlerelements mit einer von dem Wandlerelement beabstandeten Membran, das entlang der Hubachse bewegbar ist, und einem zwischen dem Wandlerelement und dem Koppelelement ausgebildeten Federbereich, der zumindest ein Federelement aufweist, das das Wandlerelement beweglich mit dem Koppelelement verbindet, und der eine Dämpfungsschicht aufweist, die das Federelement zumindest teilweise bedeckt, des Weiteren betrifft die Erfindung einen MEMS-Schallwandler sowie ein Herstellungsverfahren für eine derartige Wandlereinheit und/oder einen derartigen MEMS-Schallwandlers.

Aus der DE 10 2015 114 242 A1 ist ein MEMS-Lautsprecher mit einem Aktuator und einer Membran bekannt, die voneinander in Richtung einer Hubachse beabstandet und über eine Hubstruktur mittelbar miteinander verbunden sind. Der Aktuator ist hierbei über ein flexibles Verbindungselement mit der Hubstruktur verbunden. Das flexible Verbindungselement muss sehr filigran ausgebildet sein, um eine optimale Bewegung der Hubstruktur und des Aktuators sicherstellen zu können. Nachteilig hierbei ist, dass das flexible Verbindungselement bei mechanischen Erschütterungen - beispielsweise, wenn der MEMS-Lautsprecher auf den Boden fällt, - brechen kann. Dies führt wiederum zum Ausfall des MEMS-Lautsprechers.

Die US 2017/0325030 A1 offenbart ein MEMS, welches ein Diaphragma und eine mit dem Diaphragma verbundene Hubstruktur umfasst. Des Weiteren weist das MEMS mindestens zwei piezoelektrische Aktuatoren auf, die mit einer Vielzahl von beabstandeten Kontaktpunkten der Hubstruktur über eine Vielzahl von beabstandeten Verbindungselementen gekoppelt sind. Die mindestens zwei piezoelektrischen Aktuatoren sind so konfiguriert, dass sie eine Hubstrukturbewegung verursachen, um das Diaphragma zu verformen, wobei jeder der mindestens zwei piezoelektrischen Aktuatoren mit mindestens zwei räumlich beabstandeten Kontaktpunkten der Hubstruktur über mindestens zwei räumlich beabstandete Verbindungselemente verbunden ist.

Aufgabe der vorliegenden Erfindung ist es, die aus dem Stand der Technik bekannten Nachteile zu beseitigen, insbesondere einen MEMS-Schallwandler zu schaffen, der robuster gegen äußere mechanische Erschütterungen ist, und/oder ein Herstellungsverfahren mit dem die Herstellungskosten für dessen Herstellung reduziert werden können.

Die Aufgabe wird gelöst mit einer Wandlereinheit, einem MEMS-Schallwandler und/oder einem Herstellungsverfahren mit den Merkmalen der unabhängigen Patentansprüche.

Vorgeschlagen wird eine Wandlereinheit für einen MEMS-Schallwandler, die einen Träger umfasst. Ferner weist diese zumindest ein Wandlerelement auf, das mit dem Träger verbunden ist und entlang einer Hubachse auslenkbar ist. Die Wandlereinheit weist vorzugsweise mehrere Wandlerelemente auf. Auch umfasst die Wandlereinheit ein Koppelelement zum Verbinden des zumindest einen Wandlerelements mit einer von dem Wandlerelement beabstandeten Membran. Das Koppelelement ist entlang der Hubachse bewegbar. Überdies hinaus umfasst die Wandlereinheit einen zwischen dem Wandlerelement und dem Koppelelement ausgebildeten Federbereich, der zumindest ein Federelement aufweist. Das Federelement verbindet das Wandlerelement beweglich mit dem Koppelelement. Auch umfasst die Wandlereinheit eine Dämpfungsschicht, die das Federelement zumindest teilweise bedeckt. Die Dämpfungsschicht reduziert die Vibrationsmenge, d. h. sowohl die maximale induzierte Dehnung als auch die Dauer der Belastung, die während eines mechanischen Schocks auf das Federelement einwirkt. Hierdurch kann ein Bruch des zumindest einen Federelements verhindert werden. Des Weiteren ist die Dämpfungsschicht aus einem ausgehärteten Klebstoff ausgebildet. Hierdurch kann die Dämpfungsschicht sehr kostengünstig ausgebildet werden, wodurch die Herstellungskosten der Wandlereinheit reduziert werden können. Des Weiteren können die Materialeigenschaften der Dämpfungsschicht unabhängig von den Materialeigenschaften des Wandlerelements gewählt werden. Vorteilhafterweise können somit die Materialeigenschaften der Dämpfungsschicht derart gewählt werden, dass die Dämpfungsschicht die Beweglichkeit des Federelements möglichst wenig beeinträchtigt und zugleich das Federelement bestmöglich vor äußeren mechanischen Störeinflüssen schützt.

Vorteilhaft ist es, wenn der ausgehärtete Klebstoff elastisch ist, flexibel ist und/oder einen Elastizitätsmodul von weniger als 10 MPa aufweist. Hierdurch kann sichergestellt werden, dass die Beweglichkeit des Federelements und demnach auch die Beweglichkeit des Wandlerelements im wesentlichen nicht beeinträchtigt wird.

Des Weiteren ist es vorteilhaft, wenn der ausgehärtete Klebstoff thixotrop ist, so dass seine Viskosität infolge andauernder Deformation abnimmt. Vorteilhafterweise schützt die Dämpfungsschicht das Federelement sehr gut, wenn die Wandlereinheit außer Betrieb ist. Des Weiteren wird die Beweglichkeit des Federelements bzw. des Wandlerelements im Betrieb der Wandlereinheit erhöht bzw. verbessert.

Vorteilhaft ist es, wenn der ausgehärtete Klebstoff eine Dichte von 0,5 bis 1,5 g/cm³, insbesondere 1,09 g/cm³, aufweist.

Auch ist es vorteilhaft, wenn der ausgehärtete Klebstoff ein Epoxidharz ist. Um zu vermeiden, dass das Federelement beschädigt wird, ist es vorteilhaft, wenn der Klebstoff lösungsmittelfrei ist.

Um eine möglichst gute Beweglichkeit des Federelements sicherstellen zu können, ist es vorteilhaft, wenn der Federbereich zumindest eine durchgehende Aussparung aufweist.

Des Weiteren ist es vorteilhaft, wenn die Dämpfungsschicht die zumindest eine Aussparung zumindest teilweise abdeckt und/oder überspannt. Unter dem Begriff "abdecken" und/oder "überspannen" ist zu verstehen, dass sich die Dämpfungsschicht im Wesentlichen nicht in die Aussparung hinein erstreckt. Infolgedessen ist der die Dämpfungsschicht ausbildende Klebstoff bei der Herstellung nicht oder nur in einem Eingangsbereich in die Aussparung hineingelaufen.

Vorteile bringt es zudem mit sich, wenn sich die Aussparung in Richtung der Hubachse von einer ersten Seite des Federbereichs, die vorzugsweise im bestimmungsgemäßen Gebrauch von der dafür vorgesehenen Membran abgewandt ist, bis zu einer gegenüberliegenden zweiten Seite des Federbereichs, die vorzugsweise im bestimmungsgemäßen Gebrauch der dafür vorgesehenen Membran zugewandt ist, erstreckt.

Vorteilhaft ist es zudem, wenn sich die Aussparung in Längsrichtung des Wandlerelements vom Wandlerelement bis zum Koppelelement erstreckt.

Auch ist es von Vorteil, wenn die Aussparung eine Längsseite des Federelements freischneidet. Hierdurch kann die Beweglichkeit des Federelements verbessert werden.

Vorteilhaft ist es zudem, wenn die Dämpfungsschicht auf der ersten und/oder zweiten Seite des Federbereichs angeordnet ist.

Auch ist es von Vorteil, wenn die Aussparung in Richtung der Hubachse an der ersten und/oder zweiten Seite des Federbereichs eine Aussparungsöffnung aufweist. Vorteile bringt es zudem mit sich, wenn die Dämpfungsschicht in Richtung der Hubachse, insbesondere nur, im Bereich der Aussparungsöffnung angeordnet ist, so dass vorzugsweise ein sich an die Aussparungsöffnung anschließender Innenbereich der Aussparung klebstofffrei ist.

Ebenso ist es vorteilhaft, wenn die zumindest eine Aussparung insbesondere in einer Draufsicht einen ersten Abschnitt, der zwischen zwei gegenüberliegenden Federelementabschnitten desselben Federelements ausgebildet ist. Ferner ist es vorteilhaft, wenn die zumindest eine Aussparung vorzugsweise in einer Draufsicht einen zweiten Abschnitt, der zwischen dem Federelement und dem Wandlerelement ausgebildet ist, aufweist. Vorteilhaft ist es, wenn die zumindest eine Aussparung in einer Draufsicht einen dritten Abschnitt, der zwischen dem Federelement und dem Koppelelement ausgebildet ist, aufweist. Des Weiteren ist es vorteilhaft, wenn die zumindest eine Aussparung in einer Draufsicht einen vierten Abschnitt, der zwischen zwei benachbarten Federelementen ausgebildet ist, aufweist.

Ebenso bringt es Vorteile mit sich, wenn die Aussparung, insbesondere der erste, zweite, dritte und/oder vierte Abschnitt, eine Breite aufweist, die zu einer Viskosität des flüssigen Klebstoffs derart korrespondierend ausgebildet ist, dass der flüssige Klebstoff nicht durch die Aussparung hindurchtropft. Vorzugsweise weist die Aussparung, insbesondere der erste, zweite, dritte und/oder vierte Abschnitt, eine Breite von 5 µm bis 40 µm, insbesondere von 30 µm, auf.

Des Weiteren ist es vorteilhaft, wenn das zumindest eine Federelement in der Draufsicht zwischen zwei Aussparungen angeordnet ist.

Ebenso ist es vorteilhaft, wenn die Dämpfungsschicht eine sich an den Federbereich anschließende Endfläche des Koppelelements zumindest teilweise bedeckt. Hierdurch kann der Aufwand bei der Herstellung der Dämpfungsschicht und demnach die Kosten der Wandlereinheit reduziert werden.

Vorteilhaft ist es, wenn das Wandlerelement als Kragarm ausgebildet ist. Ferner ist es vorteilhaft, wenn das Wandlerelement eine fest mit dem Träger verbundene Basis und/oder ein gegenüber dem Träger entlang der Hubachse auslenkbares freies Ende aufweist. Vorteile bringt es mit sich, wenn das freie Ende in Richtung der Hubachse gegenüber dem Federbereich erhöht ist, so dass zwischen diesen beiden ein Absatz ausgebildet ist, an dem die Dämpfungsschicht anliegt.

Auch ist es von Vorteil, wenn die Wandlereinheit eine mehrschichtige Struktur aufweist, die zumindest eine Trägerschicht und/oder eine piezoelektrische Wandlerschicht.

Ferner ist es vorteilhaft, wenn die Trägerschicht Bestandteil des Wandlerelements, des zumindest einen Federelements und/oder des Koppelelements ist.

Ebenso ist es vorteilhaft, wenn die Wandlerschicht zumindest teilweise den Absatz ausbildet.

Vorgeschlagen wird auch ein MEMS-Schallwandler zum Erzeugen und/oder Erfassen von Schallwellen mit einer Membran, die entlang einer Hubachse auslenkbar ist, und mit einer Wandlereinheit. Die Wandlereinheit umfasst einen Träger und ein Wandlerelement, das mit dem Träger verbunden ist, von der Membran beabstandet ist und entlang der Hubachse auslenkbar ist. Auch weist die Wandlereinheit ein Koppelelement, das das Wandlerelement mit der beabstandeten Membran verbindet und das gemeinsam mit der Membran entlang der Hubachse bewegbar ist, auf. Ferner umfasst die Wandlereinheit zumindest einen zwischen dem Wandlerelement und dem Koppelelement ausgebildeten Federbereich, der zumindest ein Federelement aufweist, das das Wandlerelement beweglich mit dem Koppelelement verbindet. Zum Schutz des Federelements umfasst der Federbereich eine Dämpfungsschicht, die zumindest das Federelement zumindest teilweise bedeckt. Die Wandlereinheit ist gemäß der vorangegangenen Beschreibung ausgebildet, wobei die genannten Merkmale einzeln oder in beliebiger Kombination vorhanden sein können.

Vorgeschlagen wird auch ein Herstellungsverfahren für eine Wandlereinheit und/oder einen MEMS-Schallwandler gemäß der vorangegangenen Beschreibung, wobei die genannten Merkmale einzeln oder in beliebiger Kombination vorhanden sein können. Bei dem Herstellungsverfahren wird in einem Federbereich der Wandlereinheit auf zumindest einem Federelement eine Dämpfungsschicht ausgebildet. Hierbei wird in den Federbereich ein flüssiger Klebstoff aufgetragen, der zumindest das Federelement zumindest teilweise bedeckt. Danach wird der Klebstoff ausgehärtet, so dass durch den ausgehärteten Klebstoff die Dämpfungsschicht ausgebildet wird.

Vorteilhaft ist es, wenn der flüssige Klebstoff als Tropfen oder Linie im Federbereich aufgetragen wird. Dies erfolgt vorzugsweise mit einer Auftragevorrichtung, insbesondere eine Nadel.

Vorteile bringt es mit sich, wenn der flüssige Klebstoff eine Viskosität von 5000 bis 15000 mPa*s, insbesondere von 10000 mPa*s, aufweist. Hierdurch kann sichergestellt werden, dass der flüssige Klebstoff nicht durch die zumindest eine im Federbereich ausgebildete Aussparung durchtropft. Des Weiteren kann der flüssige Klebstoff mit der vorstehenden Viskosität schnell und zielgerichtet aufgetragen werden. Auch ist hierdurch sichergestellt, dass sich der flüssige Klebstoff in demjenigen Bereich, in dem die Dämpfungsschicht ausgebildet werden soll, zerfließen und/oder gleichmäßig verteilen kann.

Um die Herstellungsdauer der Wandlereinheit und/oder des MEMS-Schallwandlers zu reduzieren, ist es vorteilhaft, wenn der Klebstoff mittels, d.h. unter Zuführung von, Licht, insbesondere UV und/oder VIS, und/oder Wärme ausgehärtet wird.

Vorteilhaft ist es zudem, wenn der flüssige Klebstoff zum Aushärten mit einer Bestrahlungsstärke von mehr als 100 mW/cm³, insbesondere von 150 mW/cm³ bestrahlt wird. Diesbezüglich ist es vorteilhaft, wenn der flüssige Klebstoff zum Aushärten weniger als 60s, insbesondere 30s, bestrahlt wird.

Vorteilhaft ist es zudem, wenn der flüssige Klebstoff bei einer Temperatur, insbesondere Umgebungstemperatur, von mehr als 100 °C, bevorzugt bei mehr als 130°, besonders bevorzugt bei mehr als 150 °C, ausgehärtet wird. Diesbezüglich ist es vorteilhaft, wenn der flüssige Klebstoff weniger als 15 min, bevorzugt weniger als 11 min, besonders bevorzugt weniger als 6 min, der Temperatur ausgesetzt wird.

Auch ist es von Vorteil, wenn der Klebstoff während des Aushärtens um 1 vol. % bis 3 vol. %, insbesondere um 2 vol. % schrumpft.

Vorteilhaft ist es zudem, wenn ein Halbzeug der Wandlereinheit und/oder des MEMS-Schallwandlers, insbesondere zumindest der Federbereich in einem Ätzverfahren hergestellt wird und dass der flüssige Klebstoff nach dem Ätzverfahren aufgetragen wird.

Weitere Vorteile der Erfindung sind in dem nachfolgenden Ausführungsbeispiel beschrieben. Es zeigen:
- **Figur 1**: eine seitliche Schnittansicht eines schematisch dargestellten MEMS-Schallwandlers,
- **Figur 2**: eine Draufsicht des MEMS-Schallwandlers,
- **Figur 3**: einen Detailausschnitt der seitlichen Schnittansicht des MEMS-Schallwandlers im Bereich eines Federbereichs,
- **Figur 4**: einen Detailausschnitt der Draufsicht des MEMS-Schallwandlers im Bereich des Federbereichs, und
- **Figur 5**: einen Verfahrensablauf zur Herstellung einer Dämpfungsschicht eine Wandlereinheit des MEMS-Schallwandlers.

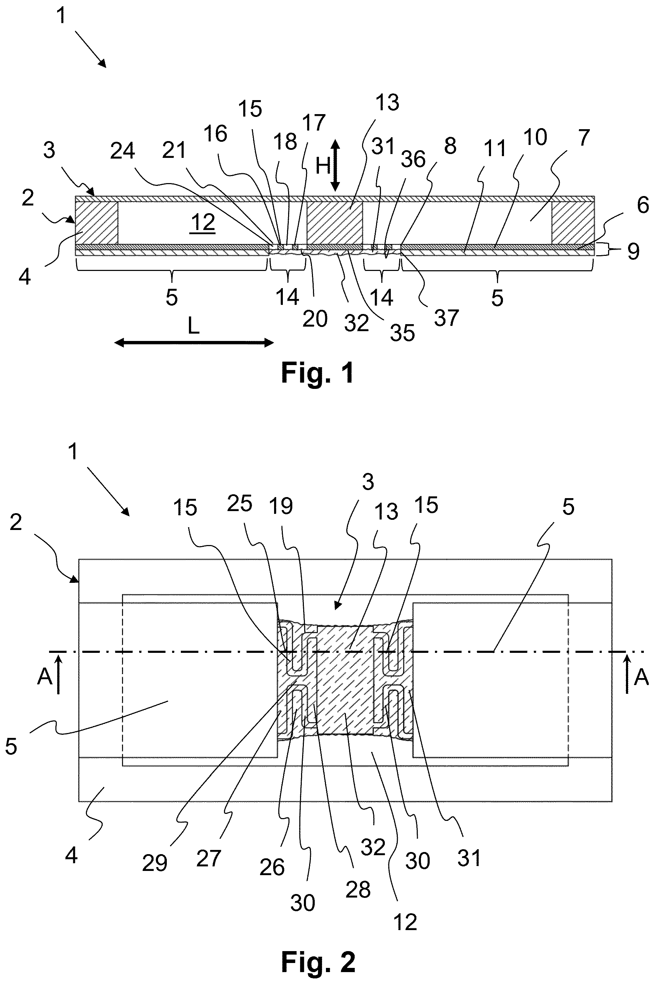

Figur 1 und 2 zeigen einen MEMS-Schallwandler 1 zum Erzeugen und/oder Erfassen von Schallwellen. Demnach kann der MEMS-Schallwandler 1 zum Erzeugen und/oder Erfassen von Schallwellen im hörbaren Wellenlängenspektrum eingesetzt werden. Zusätzlich oder alternativ kann der MEMS-Schallwandler 1 aber auch ebenso Schallwellen im Ultraschallbereich erzeugen und/oder erfassen. Aufgrund seiner kompakten Bauform eignet er sich besonders gut für den Einsatz in mobilen Geräten, wie beispielsweise Handys, Audiobrillen, Kopfhörer und/oder Hörgeräte.

Der MEMS-Schallwandler 1 umfasst eine Wandlereinheit 2. Mit dieser können Bewegungen in elektrische Signale umgewandelt werden. In diesem Fall fungiert die Wandlereinheit 2 als Mikrofon, Sensor oder Datenempfänger. Zusätzlich oder alternativ kann die Wandlereinheit aus elektrischen Signalen Bewegungen erzeugen. In diesem Fall fungiert die Wandlereinheit 2 als Lautsprecher, Aktor oder Datensender. In dem vorliegenden Ausführungsbeispiel umfasst der MEMS-Schallwandler 1 des Weiteren eine Membran 3, die mit der Wandlereinheit 2 gekoppelt ist. Die Membran 3 ist entlang einer Hubachse H auslenkbar. Sie ist vorzugsweise aus einem elastischen Material ausgebildet.

Die Wandlereinheit 2 weist einen Träger 4 und zumindest ein Wandlerelement 5 auf. Das Wandlerelement 5 ist mit dem Träger 4 verbunden. Wie aus Figur 1 hervorgeht ist das Wandlerelement 5 an einer ersten Stirnseite des Trägers 4 angeordnet. Die Membran 3 ist in ihrem Randbereich an einer gegenüberliegenden zweiten Stirnseite des Trägers 4 befestigt. Die Membran 3 kann ein vorliegend nicht dargestelltes Versteifungselement aufweisen, das vom Randbereich beabstandet ist.

In dem vorliegenden Ausführungsbeispiel ist das Wandlerelement 5 als Kragarm ausgebildet. Infolgedessen umfasst das Wandlerelement 5 eine Basis 6, die fest mit dem Träger 4 verbunden ist. Von dieser Basis 6 ausgehend erstreckt sich das Wandlerelement 5 über den Träger 4 hinaus in eine Kavität 7 des MEMS-Schallwandlers hinein. Bei dem Begriff "Kavität" handelt es sich um einen akustischen Hohlraum bzw. ein akustisches Volumen auf der Rückseite der Membran 3. Das Wandlerelement 5 umfasst ein freies Ende 8. Dieses ist an einem der Basis gegenüberliegenden Ende des Kragarms ausgebildet. Das freie Ende 8 des Wandlerelements 5 kann entlang der Hubachse H ausgelenkt werden. Hierbei wird das Wandlerelement 5 über seine Länge gebogen.

In dem vorliegenden Ausführungsbeispiel ist das Wandlerelement 5 als Bestandteil einer mehrschichtigen Struktur 9 ausgebildet. Die mehrschichtige Struktur 9 umfasst zumindest eine Trägerschicht 10 und eine Wandlerschicht 11. Vorzugsweise ist die Wandlerschicht 11 als piezoelektrische Wandlerschicht 11 ausgebildet. Zusätzlich kann die mehrschichtige Struktur 9 vorliegend nicht dargestellte weitere Schichten, wie beispielsweise Elektronenschichten und/oder Isolationsschichten, aufweisen.

Wie aus Figur 1 und 2 hervorgeht, ist die Membran 3 in Richtung der Hubachse H von dem Wandlerelement 5 beabstandet, so dass zwischen diesen beiden ein Trägerhohlraum 12 ausgebildet ist. Der Trägerhohlraum 12 bildet demnach einen Teil der akustischen Kavität 7 des MEMS-Schallwandlers 1. Um die Membran 3 mit dem Wandlerelement 5 zu koppeln, umfasst die Wandlereinheit 2 des Weiteren ein Koppelelement 13. Dieses erstreckt sich in Richtung der Hubachse H von der Membran 3 bis zum Wandlerelement 5. Vorzugsweise ist das Koppelelement 13 unmittelbar und/oder starr mit der Membran 3 verbunden. Die Membran 3 und das Koppelelement 13 schwingen demnach gemeinsam als Einheit entlang der Hubachse H.

Um Orientierungsänderungen zwischen dem Koppelelement 13 und dem Wandlerelement 5, insbesondere dem freien Ende 8, ausgleichen zu können, umfasst die Wandlereinheit 2 des Weiteren einen Federbereich 14. Dieser ist zwischen dem Wandlerelement 5 und dem Koppelelement 13 ausgebildet. Das Wandlerelement 5 ist somit über den Federbereich 14 mittelbar mit dem Koppelelement 13 verbunden. Hierfür umfasst der Federbereich 14 zumindest ein erstes Federelement 15. Dieses zumindest eine erste Federelement 15 verbindet demnach das Wandlerelement 5 beweglich mit dem Koppelelement 13.

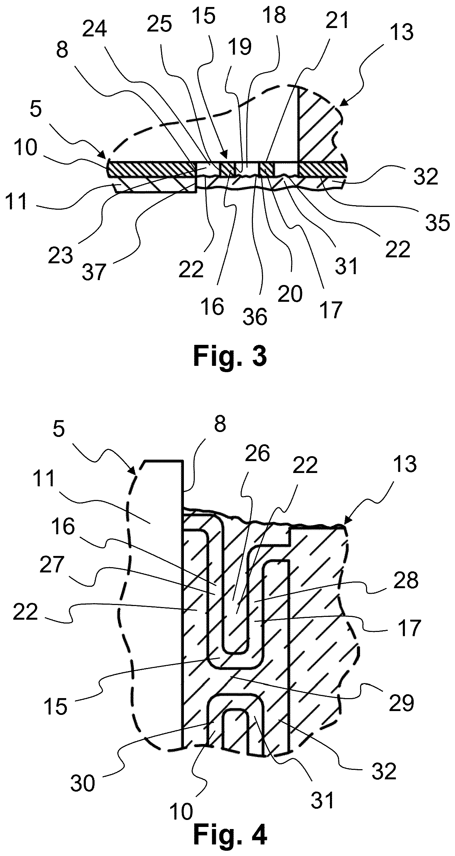

Wie insbesondere aus den in Figur 3 und 4 dargestellten Detailausschnitten hervorgeht, kann das erste Federelement 15 eine Mäanderform aufweisen. Vorliegend ist das erste Federelement 15 derart geformt, dass es zwei gegenüberliegende Federelementabschnitte 16, 17 aufweist.

Der Federbereich 14 umfasst eine erste Aussparung 18, die eine Kontur des ersten Federelements 15 bestimmt. Die erste Aussparung 18 schneidet eine erste Längsseite 19 des ersten Federelements 15 frei. Hierfür erstreckt sich die erste Aussparung 18 in Längsrichtung des Wandlerelements 5 vom freien Ende 8 - zum Koppelelement 13.

Der Federbereich 14 umfasst gemäß Figur 3 in Richtung der Hubachse H eine erste Seite 20 und eine gegenüberliegende zweite Seite 21. Hierbei ist die erste Seite 20 von der Membran 3 abgewandt und die gegenüberliegende zweite Seite 21 der Membran 3 zugewandt. Die erste Aussparung 18 ist durchgehend ausgebildet. Infolgedessen erstreckt sich diese in Richtung der Hubachse von der ersten Seite 20 durchgehend bis zur zweiten Seite 21. An der ersten Seite 20 und der zweiten Seite 21 umfasst die erste Aussparung 18 somit jeweils eine Aussparungsöffnung 22, von denen in Figur 3 aus Gründen der Übersichtlichkeit nur eine mit einem Bezugszeichen versehen ist. Zwischen den beiden Aussparungsöffnungen 22 ist somit ein Innenbereich 23 der ersten Aussparung 18 ausgebildet.

Wie insbesondere aus Figur 4 hervorgeht, umfasst der Federbereich 14 eine zweite Aussparung 24. Diese ist gemäß der vorangegangenen Beschreibung analog zur ersten Aussparung 18 ausgebildet. Die zweite Aussparung 24 schneidet eine zweite Längsseite 25 des ersten Federelements 15 frei. Das erste Federelement 15 befindet sich somit in einer Draufsicht zwischen den beiden Aussparungen 18, 24. Die Kontur des ersten Federelements 15 ist somit durch die beiden benachbarten Aussparungen 18, 24 bestimmt.

In dem vorliegenden Ausführungsbeispiel umfasst die Wandlereinheit 2 gemäß Figur 2 und 4 zusätzlich zum ersten Federelement 15 ein zweites Federelement 30, dass das Wandlerelement 5 mit dem Koppelelement 13 verbindet. Das zweite Federelement 30 kann hierbei wie das erste Federelement 15 gemäß der vorangegangenen Beschreibung ausgebildet sein. In dem vorliegenden Ausführungsbeispiel sind die beiden Federelemente 15, 30 zueinander lediglich gespiegelt.

Gemäß Figur 4 umfasst die erste Aussparung 18 einen ersten Abschnitt 26, der zwischen den beiden gegenüberliegenden Federelementabschnitten 16, 17 des ersten Federelements 15 ausgebildet ist. Die zweite Aussparung 24 weist einen zweiten Abschnitt 27 auf, der zwischen dem ersten Federelement 15, insbesondere den ersten Federelementabschnitten 16, und dem Wandlerelement 5 ausgebildet ist. Auch weist die zweite Aussparung 24 einen dritten Abschnitt 28 auf, der zwischen dem ersten Federelement, insbesondere dem zweiten Federelementabschnitt 17, und dem Koppelelement 13 ausgebildet ist. Des Weiteren umfasst die zweite Aussparung 24 einen vierten Abschnitt 29, der zwischen dem ersten Federelement 15 und dem zu diesem benachbarten zweiten Federelement 30 ausgebildet ist. Die zweite Aussparung 24 ist somit sowohl dem ersten Federelement 15 als auch den zweiten Federelement 30 zugeordnet.

Das zumindest eine Federelement 15, 30 muss sehr filigran ausgebildet sein, um eine optimale Bewegung des Koppelelements 13 und des Wandlerelements 5 sicherstellen zu können. Nachteilig hierbei ist, dass das zumindest eine Federelement 15, 30 bei mechanischen Erschütterungen brechen kann, was wiederum zum Ausfall der Wandlereinheit 2 bzw. des gesamten MEMS-Schallwandlers 1 führt. Zum Schutz des zumindest einen Federelements 15, 30 umfasst die Wandlereinheit 2 in ihrem Federbereich 14 deshalb eine Dämpfungsschicht 31. Die Dämpfungsschicht 31 ist hierbei auf und/oder über dem zumindest einen Federelement 15, 30 angeordnet. Sie Reduziert die Vibrationsmenge, d. h. sowohl die maximale induzierte Dehnung als auch die Dauer der Belastung, die während eines mechanischen Schocks auf das zumindest eine Federelement 15, 30 einwirkt. Hierdurch kann ein Bruch des zumindest einen Federelements 15, 30 verhindert werden.

Die Dämpfungsschicht 31 bedeckt hierbei das zumindest eine Federelement 15, 30 zumindest teilweise. In dem vorliegenden Ausführungsbeispiel bedeckt die Dämpfungsschicht 31 eine Seite des Federelements 15, 30 vollständig und/oder über die gesamte Länge des Federelements 15, 30. Wie aus Figur 1 und 3 hervorgeht, ist die Dämpfungsschicht 31 auf der ersten Seite 20 des Federbereichs 14 aufgetragen. Alternativ oder zusätzlich könnte die Dämpfungsschicht 31 aber auch auf der zweiten Seite 21 des Federbereichs 14 aufgetragen sein.

Die Dämpfungsschicht 31 ist in dem Federbereich 14 nicht nur über dem zumindest einen Federelement 15, 30, sondern zusätzlich auch zumindest teilweise über die zumindest eine Aussparung 18, 24 des Federbereichs 14 angeordnet. Hierdurch wird das zumindest eine Federelement 15, 30 zusätzlich gestützt, gedämpft und/oder stabilisiert.

Die Dämpfungsschicht 31 ist aus einem ausgehärteten Klebstoff 32 ausgebildet. Im ausgehärteten Zustand ist dieser Klebstoff 32 elastisch, so dass dieser die Beweglichkeit des zumindest einen Federelements 15, 30 im Wesentlichen nicht negativ beeinflusst. Aus diesem Grund ist es ferner vorteilhaft, wenn der Klebstoff 32 thixotrop ist. Dies bedeutet, dass seine Viskosität bei andauernder Deformation abnimmt. Infolgedessen reduziert sich bei aktiver Wandlereinheit 2 der Widerstand, den die Dämpfungsschicht 31 dem zumindest einen Federelements 15, 30 entgegenbringt. Auch ist es vorteilhaft, wenn der Klebstoff 32 lösungsmittelfrei ist, so dass das zumindest eine Federelement 15, 30, das vorzugsweise aus der Trägerschicht 10 der mehrschichtigen Struktur 9 ausgebildet ist, nicht angegriffen wird.

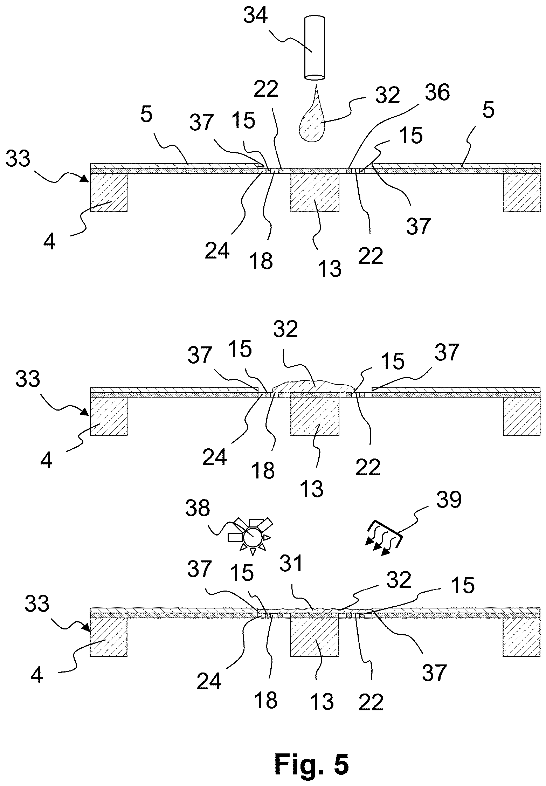

Figur 5 zeigt ein Herstellungsverfahren, um die Dämpfungsschicht 31 auf dem Federbereich 14 auszubilden. Zu diesem Zeitpunkt des Herstellungsverfahrens ist die Membran 3 vorzugsweise noch nicht an dem Träger 4 angeordnet. Figur 5 zeigt ein Halbzeug der Wandlereinheit 2. Zur Herstellung des in Figur 5 dargestellten Halbzeugs 33 wurden zuvor auf einem Trägersubstrat, insbesondere einem Siliziumsubstrat, mehrere Schichten, insbesondere zumindest die Trägerschicht 10, die Wandlerschicht 11 und/oder Elektronenschichten, aufgetragen. Anschließend wurde in einem Ätzverfahren das Trägersubstrat zur Ausbildung des Trägerhohlraums 12 zumindest teilweise weggeätzt. Im Rahmen dieses Ätzverfahrens wurden auch die aufgetragenen Schichten bereichsweise und/oder teilweise weggeätzt, um die mehrschichtige Struktur 9 auszubilden, durch die wiederum das zumindest eine Wandlerelement 5 und das zumindest eine Federelement 15, 30 ausgebildet wurde. Infolgedessen wurde die zumindest eine Aussparung 18, 24 des Federbereichs 14 durch das bereichsweise Wegätzen der Trägerschicht 10 ausgebildet.

Nach der Ausbildung des Halbzeugs 33 wird gemäß Figur 5 zur Ausbildung der Dämpfungsschicht 31 der flüssige Klebstoff 32 auf den Federbereich 14 aufgetragen. Dies erfolgt gemäß dem in Figur 5 dargestellten Ausführungsbeispiel auf der ersten Seite 20 des Federbereichs 14 und/oder zur Ausnutzung der Schwerkraft von oben. Das Auftragen erfolgt mittels einer Auftragevorrichtung 34. Diese ist vorliegend als Injektionsnadel ausgebildet. Infolgedessen wird der flüssige Klebstoff 32 als, insbesondere ein einziger, Tropfen aufgetragen. In einem vorliegend nicht dargestellten Ausführungsbeispiel könnte der flüssige Kleber 32 aber auch als Linie aufgetragen werden.

Das Koppelelement 13 ist in einem Zentrum der Wandlereinheit 2 angeordnet. Aufgrund dessen wird der flüssige Klebstoff 32 gemäß Figur 5 auf eine Endfläche 35 des Koppelelements 13 injiziert. Von dort aus verteilt sich der flüssige Klebstoff 32, insbesondere aufgrund der Schwerkraft, seitlich in Richtung des zumindest einen angrenzenden Federbereichs 14. Hierbei bedeckt der flüssige Klebstoff 32 eine Außenseite 36 des zumindest einen Federelements 15, 30. Der flüssige Klebstoff 32 weist eine Viskosität von 5000 bis 15.000 mPa*s, insbesondere von 10000 mPa*s, auf. Des Weiteren ist eine Breite der zumindest einen Aussparung 18, 24 derart klein bzw. korrespondierend zur Viskosität des flüssigen Klebstoffes 32 ausgebildet, dass der flüssige Klebstoff 32 zumindest in einem Abschnitt 26, 27, 28, 29 der zumindest einen Aussparung 18, 24 im Wesentlichen nicht eindringen kann. Infolgedessen fließt der flüssige Klebstoff 32 auch über diese zumindest eine Aussparung 18, 24 hinweg. Der flüssige Klebstoff 32 überspannt und/oder überdeckt somit die korrespondierende Aussparungsöffnung 22 der zumindest einen Aussparung 18, 24. Infolgedessen bleibt der Innenbereich 23 der zumindest einen Aussparung 18, 24 klebstofffrei. Der flüssige Klebstoff 32 kann somit nicht durch die durch die zumindest eine Aussparung 18, 24 ausgebildeten Schlitze durchtropfen.

Gemäß Figur 5 verteilt sich der flüssige Klebstoff 32 somit gleichmäßig über die Endfläche 35 des Koppelelements 13 und des zumindest einen Federbereichs 14. Wie insbesondere aus Figur 3 und 5 hervorgeht, ist das freie Ende 8 des Wandlerelements 5 gegenüber dem benachbarten Federbereich 14 in Richtung der Hubachse H erhöht, so dass zwischen diesen beiden ein Absatz 37 ausgebildet ist. Dieser Absatz 37 begrenzt seitlich den für die Dämpfungsschicht 31 vorgesehenen Raum, in dem sich der flüssige Klebstoff 32 verteilen kann. Die Menge des flüssigen Klebstoffes 32 ist hierbei derart dosiert, dass der flüssige Klebstoff 32 nicht über den Absatz 37 übertritt. Nach dem Aushärten des Klebstoffes 32 liegt die Dämpfungsschicht 31 somit an diesem Abs. 37 an.

Nachdem sich der flüssige Klebstoff 32 in dem zumindest einen Federbereich 14 auf der ersten Seite 20 gleichmäßig verteilt hat, wird dieser ausgehärtet. Dies erfolgt mittels Licht, insbesondere UV und/oder VIS, und/oder mittels Wärme. Infolgedessen wird der flüssige Klebstoff 32 von einer Lichtquelle 38 bestrahlt und/oder die Umgebung über eine Wärmequelle 39 erwärmt.

Anschließend wird die Membran 3 an der Wandlereinheit 2 befestigt, so dass der MEMS-Schallwandler 1 ausgebildet ist.

Die vorliegende Erfindung ist nicht auf die dargestellten und beschriebenen Ausführungsbeispiele beschränkt. Abwandlungen im Rahmen der Patentansprüche sind ebenso möglich wie eine Kombination der Merkmale, auch wenn diese in unterschiedlichen Ausführungsbeispielen dargestellt und beschrieben sind.

### Bezugszeichenliste

- 1: MEMS-Schallwandler
- 2: Wandlereinheit
- 3: Membran
- 4: Träger
- 5: Wandlerelement
- 6: Basis
- 7: Kavität
- 8: freies Ende
- 9: mehrschichtige Struktur
- 10: Trägerschicht
- 11: Wandlerschicht
- 12: Trägerhohlraum
- 13: Koppelelement
- 14: Federbereich
- 15: erstes Federelement
- 16: Erster Federelementabschnitt
- 17: Zweiter Federelementabschnitt
- 18: Erste Aussparung
- 19: Erste Längsseite
- 20: Erste Seite des Federbereichs
- 21: Zweite Seite des Federbereichs
- 22: Aussparungsöffnung
- 23: Innenbereich der Aussparung
- 24: Zweite Aussparung
- 25: Zweite Längsseite
- 26: Erster Abschnitt
- 27: zweiter Abschnitt
- 28: dritter Abschnitt
- 29: vierter Abschnitt
- 30: zweites Federelement
- 31: Dämpfungsschicht
- 32: Klebstoff
- 33: Halbzeug
- 34: Auftragevorrichtung
- 35: Endfläche
- 36: Außenseite
- 37: Absatz
- 38: Lichtquelle
- 39: Wärmequelle

- H: Hubachse

## Patentansprüche

1. Wandlereinheit (2) für einen MEMS-Schallwandler mit einem Träger (4),
zumindest einem Wandlerelement (5), das mit dem Träger (4) verbunden ist und entlang einer Hubachse (H) auslenkbar ist,
einem Koppelelement (13) zum Verbinden des Wandlerelements (5) mit einer von dem Wandlerelement (5) beabstandeten Membran (3), das entlang der Hubachse (H) bewegbar ist, und
einem zwischen dem Wandlerelement (5) und dem Koppelelement (13) ausgebildeten Federbereich (14), der zumindest ein Federelement (15, 30) aufweist, das das Wandlerelement (5) beweglich mit dem Koppelelement (13) verbindet,
und der eine Dämpfungsschicht (31) aufweist, die das Federelement (15, 30) zumindest teilweise bedeckt,
dadurch gekennzeichnet,
dass die Dämpfungsschicht (31) aus einem ausgehärteten Klebstoff (32) ausgebildet ist.

2. Wandlereinheit nach dem vorherigen Anspruch, **dadurch gekennzeichnet, dass** der ausgehärtete Klebstoff (32) elastisch ist und/oder einen Elastizitätsmodul von weniger als 10 MPa aufweist und/oder dass der ausgehärtete Klebstoff (32) thixotrop ist, so dass seine Viskosität infolge andauernder Deformation abnimmt.

3. Wandlereinheit nach einem oder mehreren der vorherigen Ansprüche, **dadurch gekennzeichnet, dass** der ausgehärtete Klebstoff (32) eine Dichte von 0,5 bis 1,5 g/cm³, insbesondere 1,09 g/cm³, aufweist und/oder dass der ausgehärtete Klebstoff (32) lösungsmittelfrei ist.

4. Wandlereinheit nach einem oder mehreren der vorherigen Ansprüche, **dadurch gekennzeichnet, dass** der Federbereich (14) zumindest eine durchgehende Aussparung (18, 24) aufweist, wobei die Aussparung (18, 24) vorzugsweise eine Längsseite (19, 25) des Federelements freischneidet, und
dass die Dämpfungsschicht (31) die zumindest eine Aussparung (18, 24) zumindest teilweise abdeckt und/oder überspannt.

5. Wandlereinheit nach einem oder mehreren der vorherigen Ansprüche, **dadurch gekennzeichnet, dass** die Dämpfungsschicht (31) auf einer ersten und/oder zweiten Seite (20, 21) des Federbereichs (14) angeordnet ist.

6. Wandlereinheit nach einem oder mehreren der vorherigen Ansprüche, **dadurch gekennzeichnet, dass** die Dämpfungsschicht (31) in Richtung der Hubachse (H) im Bereich einer Aussparungsöffnung (22) der Aussparung (18, 24) angeordnet ist und diese überspannt, so dass ein sich an die Aussparungsöffnung (22) anschließender Innenbereich (23) der Aussparung (18, 24) klebstofffrei ist.

7. Wandlereinheit nach einem oder mehreren der vorherigen Ansprüche, **dadurch gekennzeichnet, dass** die zumindest eine Aussparung (18, 24) einen ersten Abschnitt (26), der zwischen zwei gegenüberliegenden Federelementabschnitten (16, 17) desselben Federelements (15, 30) ausgebildet ist,
einen zweiten Abschnitt (27), der zwischen dem Federelement (15, 30) und dem Wandlerelement (5) ausgebildet ist,
einen dritten Abschnitt (28), der zwischen dem Federelement (15, 30) und dem Koppelelement (13) ausgebildet ist, und/oder
einen vierten Abschnitt (29), der zwischen zwei benachbarten Federelementen (15, 30) ausgebildet ist, aufweist.

8. Wandlereinheit nach einem oder mehreren der vorherigen Ansprüche, **dadurch gekennzeichnet, dass** die Dämpfungsschicht (31) eine sich an den Federbereich (14) anschließende Endfläche (35) des Koppelelements (13) zumindest teilweise bedeckt.

9. Wandlereinheit nach einem oder mehreren der vorherigen Ansprüche, **dadurch gekennzeichnet, dass** ein freies Ende (8) in Richtung der Hubachse (H) gegenüber dem Federbereich (14) erhöht ist, so dass zwischen diesen beiden ein Absatz (37) ausgebildet ist, an dem die Dämpfungsschicht (31) anliegt.

10. MEMS-Schallwandler zum Erzeugen und/oder Erfassen von Schallwellen
mit einer Membran (3), die entlang einer Hubachse (H) auslenkbar ist, und
mit einer Wandlereinheit (2) umfassend
einen Träger (4),
ein Wandlerelement (5), das mit dem Träger (4) verbunden ist, von der Membran (3) beabstandet ist und entlang der Hubachse (H) auslenkbar ist,
ein Koppelelement (13), das das Wandlerelement (5) mit der beabstandeten Membran (3) verbindet und das gemeinsam mit der Membran (3) entlang der Hubachse (H) bewegbar ist, und
zumindest einen zwischen dem Wandlerelement (5) und dem Koppelelement (13) ausgebildeten Federbereich (14), der zumindest ein Federelement (15, 30) aufweist, das das Wandlerelement (5) beweglich mit dem Koppelelement (13) verbindet, und der eine Dämpfungsschicht (31) aufweist, die das Federelement (15, 30) zumindest teilweise bedeckt,
**dadurch gekennzeichnet,**
**dass** die Wandlereinheit (2) gemäß einem oder mehreren der vorherigen Ansprüche ausgebildet ist.

11. Herstellungsverfahren für eine Wandlereinheit (2) und/oder einen MEMS-Schallwandler gemäß einem oder mehreren der vorherigen Ansprüche,
bei dem in einem Federbereich (14) der Wandlereinheit (2) auf zumindest einem Federelement (15, 30) eine Dämpfungsschicht (31) ausgebildet wird,
**dadurch gekennzeichnet,**
**dass** in den Federbereich (14) ein flüssiger Klebstoff (32) aufgetragen wird, der zumindest das Federelement (15, 30) zumindest teilweise bedeckt und
**dass** der Klebstoff (32) ausgehärtet wird, so dass durch den ausgehärteten Klebstoff (32) die Dämpfungsschicht (31) ausgebildet wird.

12. Herstellungsverfahren nach dem vorherigen Anspruch, **dadurch gekennzeichnet, dass** der flüssige Klebstoff (32) als Tropfen oder Line im Federbereich (14) aufgetragen wird und/oder
dass der flüssige Klebstoff (32) eine Viskosität von 5000 bis 15000 mPa*s, insbesondere von 10000 mPa*s, aufweist.

13. Herstellungsverfahren nach einem oder mehreren der Ansprüche 11 oder 12,
**dadurch gekennzeichnet, dass** der Klebstoff (32) mittels Licht und/oder Wärme ausgehärtet wird und/oder
dass der flüssige Klebstoff (32) zum Aushärten mit einer Bestrahlungsstärke von mehr als 100 mW/cm³, insbesondere von 150 mW/cm³, und/oder weniger als 60s, insbesondere 30s, bestrahlt wird.

14. Herstellungsverfahren nach einem oder mehreren der Ansprüche 11 bis 13,
**dadurch gekennzeichnet, dass** der flüssige Klebstoff (32) bei einer Temperatur von mehr als 100 °C, bevorzugt bei mehr als 130°, besonders bevorzugt bei mehr als 150 °C, ausgehärtet wird und/oder weniger als 15 min, bevorzugt weniger als 11 min, besonders bevorzugt weniger als 6 min, der Temperatur ausgesetzt wird.

15. Herstellungsverfahren nach einem oder mehreren der Ansprüche 11 bis 14,
**dadurch gekennzeichnet, dass** der Federbereich (14) in einem Ätzverfahren hergestellt wird und dass der flüssige Klebstoff (32) nach dem Ätzverfahren aufgetragen wird.

## Claims

1. Transducer unit (2) for a MEMS sound transducer having a support (4),
at least one transducer element (5) which is connected to the support (4) and can be deflected along a reciprocation axis (H),
a coupling element (13) for connecting the transducer element (5) to a diaphragm (3) which is spaced apart from the transducer element (5) and can be moved along the reciprocation axis (H), and
a spring region (14) which is formed between the transducer element (5) and the coupling element (13) and has at least one spring element (15, 30) which movably connects the transducer element (5) to the coupling element (13),
and which has a damping layer (31) which at least partially covers the spring element (15, 30),
**characterized in that**
the damping layer (31) is formed from a cured adhesive (32).

2. Transducer unit according to the preceding claim, **characterized in that** the cured adhesive (32) is elastic and/or has an elasticity modulus of less than 10 MPa, and/or
the cured adhesive (32) is thixotropic, such that its viscosity decreases as a result of permanent deformation.

3. Transducer unit according to one or more of the preceding claims,
**characterized in that** the cured adhesive (32) has a density of 0.5 to 1.5 g/cm³, in particular 1.09 g/cm³, and/or **in that** the cured adhesive (32) is solventless.

4. Transducer unit according to one or more of the preceding claims,
**characterized in that** the spring region (14) has at least one continuous recess (18, 24), wherein the recess (18, 24) preferably cuts free a longitudinal side (19, 25) of the spring element, and
the damping layer (31) at least partially covers and/or spans the at least one recess (18, 24).

5. Transducer unit according to one or more of the preceding claims,
**characterized in that** the damping layer (31) is arranged on a first and/or second side (20, 21) of the spring region (14).

6. Transducer unit according to one or more of the preceding claims,
**characterized in that** the damping layer (31) is arranged in the direction of the reciprocation axis (H) in the region of a recess opening (22) of the recess (18, 24) and spans the latter, such that an inner region (23) of the recess (18, 24) adjoining the recess opening (22) is adhesive-free.

7. Transducer unit according to one or more of the preceding claims,
**characterized in that** the at least one recess (18, 24) has a first section (26) which is formed between two opposite spring element sections (16, 17) of the same spring element (15, 30),
a second section (27) which is formed between the spring element (15, 30) and the transducer element (5),
a third section (28) which is formed between the spring element (15, 30) and the coupling element (13), and/or
a fourth section (29) which is formed between two adjacent spring elements (15, 30).

8. Transducer unit according to one or more of the preceding claims,
**characterized in that** the damping layer (31) at least partially covers an end face (35) of the coupling element (13) adjoining the spring region (14).

9. Transducer unit according to one or more of the preceding claims,
**characterized in that** a free end (8) is raised in the direction of the reciprocation axis (H) with respect to the spring region (14), such that a shoulder (37), against which the damping layer (31) bears, is formed between these two.

10. MEMS sound transducer for generating and/or detecting sound waves having a diaphragm (3) which can be deflected along a reciprocation axis (H), and
having a transducer unit (2) comprising
a support (4),
a transducer element (5) which is connected to the support (4), is spaced apart from the diaphragm (3) and can be deflected along the reciprocation axis (H),
a coupling element (13) which connects the transducer element (5) to the spaced-apart diaphragm (3) and can be moved along the reciprocation axis (H) together with the diaphragm (3), and
at least one spring region (14) which is formed between the transducer element (5) and the coupling element (13), has at least one spring element (15, 30) which movably connects the transducer element (5) to the coupling element (13), and has a damping layer (31) which at least partially covers the spring element (15, 30),
**characterized in that**
the transducer unit (2) is designed according to one or more of the preceding claims.

11. Manufacturing method for a transducer unit (2) and/or a MEMS sound transducer according to one or more of the preceding claims,
in which a damping layer (31) is formed on at least one spring element (15, 30) in a spring region (14) of the transducer unit (2),
**characterized in that**
a liquid adhesive (32) which at least partially covers at least the spring element (15, 30) is applied in the spring region (14), and
the adhesive (32) is cured, such that the damping layer (31) is formed by the cured adhesive (32).

12. Manufacturing method according to the preceding claim, **characterized in that** the liquid adhesive (32) is applied as a drop or line in the spring region (14), and/or
the liquid adhesive (32) has a viscosity of 5000 to 15000 mPa*s, in particular of 10000 mPa*s.

13. Manufacturing method according to one or more of claims 11 or 12,
**characterized in that** the adhesive (32) is cured by means of light and/or heat, and/or
for curing, the liquid adhesive (32) is irradiated with an irradiation intensity of more than 100 mW/cm³, in particular of 150 mW/cm³, and/or less than 60 s, in particular 30 s.

14. Manufacturing method according to one or more of claims 11 to 13,
**characterized in that** the liquid adhesive (32) is cured at a temperature of more than 100°C, preferably at more than 130°C, particularly preferably at more than 150°C, and/or
is exposed to the temperature for less than 15 min, preferably less than 11 min, particularly preferably less than 6 min.

15. Manufacturing method according to one or more of claims 11 to 14,
**characterized in that** the spring region (14) is manufactured in an etching process, and **in that** the liquid adhesive (32) is applied after the etching process.

## Revendications

1. Unité de transducteur (2) pour un transducteur acoustique MEMS comprenant un support (4),
au moins un élément de transducteur (5) qui est connecté au support (4) et qui est déflectible le long d'un axe de levage (H),
un élément de couplage (13) pour connecter l'élément de transducteur (5) à un diaphragme (3) espacé de l'élément de transducteur (5), qui est déplaçable le long de l'axe de levage (H), et
une zone de ressort (14) formée entre l'élément de transducteur (5) et l'élément de couplage (13), qui comporte au moins un élément de ressort (15, 30) qui connecte l'élément de transducteur (5) de manière déplaçable à l'élément de couplage (13),
et qui comporte une couche d'amortissement (31) qui recouvre au moins partiellement l'élément de ressort (15, 30),
**caractérisée en ce que**
la couche d'amortissement (31) est formée d'un adhésif durci (32).

2. Unité de transducteur selon la revendication précédente, **caractérisée en ce que** l'adhésif durci (32) est élastique et/ou présente un module d'élasticité inférieur à 10 MPa et/ou
l'adhésif durci (32) est thixotropique, de sorte que sa viscosité diminue en raison d'une déformation permanente.

3. Unité de transducteur selon l'une ou plusieurs des revendications précédentes, **caractérisée en ce que** l'adhésif durci (32) présente une densité de 0,5 à 1,5 g/cm3 , en particulier de 1,09 g/cm3 , et/ou **en ce que** l'adhésif durci (32) est exempt de solvant.

4. Unité de transducteur selon l'une ou plusieurs des revendications précédentes, **caractérisée en ce que** la zone de ressort (14) comporte au moins un évidement continu (18, 24), l'évidement (18, 24) découpant de préférence un côté longitudinal (19, 25) de l'élément de ressort, et la couche d'amortissement (31) recouvre et/ou enjambe au moins partiellement l'au moins un évidement (18, 24).

5. Unité de transducteur selon l'une ou plusieurs des revendications précédentes, **caractérisée en ce que** la couche d'amortissement (31) est disposée sur un premier et/ou un deuxième côté (20, 21) de la zone de ressort (14).

6. Unité de transducteur selon l'une ou plusieurs des revendications précédentes, **caractérisée en ce que** la couche d'amortissement (31) est disposée dans la direction de l'axe de levage (H) dans la zone d'une ouverture d'évidement (22) de l'évidement (18, 24) et enjambe celle-ci, de sorte qu'une zone intérieure (23) de l'évidement (18, 24) se raccordant à l'ouverture d'évidement (22) est exempte d'adhésif.

7. Unité de transducteur selon l'une ou plusieurs des revendications précédentes, **caractérisée en ce que** l'au moins un évidement (18, 24) comporte une première section (26) qui est formée entre deux sections d'élément de ressort opposées (16, 17) du même élément de ressort (15, 30),
une deuxième section (27) qui est formée entre l'élément de ressort (15, 30) et l'élément de transducteur (5),
une troisième section (28) qui est formée entre l'élément de ressort (15, 30) et l'élément de couplage (13), et/ou
une quatrième section (29) qui est formée entre deux éléments de ressort adjacents (15, 30).

8. Unité de transducteur selon l'une ou plusieurs des revendications précédentes, **caractérisée en ce que** la couche d'amortissement (31) recouvre au moins partiellement une surface d'extrémité (35) de l'élément de couplage (13) se raccordant à la zone de ressort (14).

9. Unité de transducteur selon l'une ou plusieurs des revendications précédentes, **caractérisée en ce qu'**une extrémité libre (8) est surélevée dans la direction de l'axe de levage (H) par rapport à la zone de ressort (14), de sorte qu'un épaulement (37) est formé entre ces deux, contre lequel la couche d'amortissement (31) s'applique.

10. Transducteur acoustique **MEMS** pour générer et/ou détecter des ondes acoustiques
avec un diaphragme (3) qui est déflectible le long d'un axe de levage (H), et
avec une unité de transducteur (2) comprenant
un support (4),
un élément de transducteur (5) qui est connecté au support (4), qui est espacé du diaphragme (3) et qui est déflectible le long de l'axe de levage (H),
un élément de couplage (13) qui connecte l'élément de transducteur (5) au diaphragme (3) espacé et qui est déplaçable conjointement avec le diaphragme (3) le long de l'axe de levage (H), et
au moins une zone de ressort (14) formée entre l'élément de transducteur (5) et l'élément de couplage (13), qui comporte au moins un élément de ressort (15, 30) qui connecte l'élément de transducteur (5) de manière déplaçable à l'élément de couplage (13), et qui comporte une couche d'amortissement (31) qui recouvre au moins partiellement l'élément de ressort (15, 30),
**caractérisée en ce que**
l'unité de transducteur (2) est réalisée selon l'une ou plusieurs des revendications précédentes.

11. Procédé de fabrication pour une unité de transducteur (2) et/ou un transducteur acoustique MEMS selon l'une ou plusieurs des revendications précédentes,
dans lequel une couche d'amortissement (31) est formée dans une zone de ressort (14) de l'unité de transducteur (2) sur au moins un élément de ressort (15, 30),
**caractérisée en ce que**
un adhésif liquide (32) est appliqué dans la zone de ressort (14), qui recouvre au moins partiellement au moins l'élément de ressort (15, 30) et
l'adhésif (32) est durci, de sorte que la couche d'amortissement (31) est formée par l'adhésif durci (32).

12. Procédé de fabrication selon la revendication précédente, **caractérisé en ce que** l'adhésif liquide (32) est appliqué sous forme de goutte ou de ligne dans la zone de ressort (14) et/ou
l'adhésif liquide (32) présente une viscosité de 5000 à 15000 mPa*s, en particulier de 10000 mPa*s.

13. Procédé de fabrication selon l'une ou plusieurs des revendications 11 ou 12, **caractérisé en ce que** l'adhésif (32) est durci au moyen de lumière et/ou de chaleur et/ou
l'adhésif liquide (32) est irradié pour le durcissement avec une intensité d'irradiation de plus de 100 mW/cm³ , en particulier de 150 mW/cm³ , et/ou de moins de 60 s, en particulier de 30 s.

14. Procédé de fabrication selon l'une ou plusieurs des revendications 11 à 13, **caractérisé en ce que** l'adhésif liquide (32) est durci à une température de plus de 100 °C, de préférence à plus de 130 °C, de manière particulièrement préférée à plus de 150 °C, et/ou
est exposé à la température pendant moins de 15 min, de préférence moins de 11 min, de manière particulièrement préférée moins de 6 min.

15. Procédé de fabrication selon l'une ou plusieurs des revendications 11 à 14, **caractérisé en ce que** la zone de ressort (14) est fabriquée dans un procédé de gravure et **en ce que** l'adhésif liquide (32) est appliqué après le procédé de gravure.
